# EUROPÄISCHE PATENTSCHRIFT

(11) **EP 1 826 810 B1**
(45) Veröffentlichungstag und Bekanntmachung des Hinweises auf die Patenterteilung: **05.12.2012**
(21) Anmeldenummer: 07003217.2
(22) Anmeldetag: 15.02.2007
(51) Int. Cl.: H01J 37/32, C23C 14/32

(54) **Anordnung für die Separation von Partikeln aus einem Plasma**
Assembly for separating particles from a plasma
Agencement de séparation de particules à partir d'un plasma

(30) Priorität: 22.02.2006 DE 102006009160
(43) Veröffentlichungstag der Anmeldung: 29.08.2007
(73) Patentinhaber: Fraunhofer-Gesellschaft zur Förderung der angewandten Forschung e.V., 80686 München (DE)
(72) Erfinder: Meyer, Carl-Friedrich, Dr. rer. nat., 01328 Dresden (DE)
(74) Vertreter: Pfenning, Meinig & Partner GbR

(56) Entgegenhaltungen:
- WO-A1-00/13201
- DE-A1- 10 240 337
- US-A- 4 929 321
- US-A- 5 840 163
- US-A- 6 024 851
- US-A1- 2002 007 796

## Beschreibung

Die Erfindung betrifft eine Anordnung für die Separation von Partikeln aus einem Plasma, das für die Beschichtung von Substraten unter Vakuumbedingungen eingesetzt wird. Sie kann besonders vorteilhaft bei einem Verfahren, bei dem das Plasma mittels elektrischer Bogenentladung gebildet wird, eingesetzt werden, da bekanntermaßen der Anteil größerer Partikel im Plasma hoch ist und diese sich als so genannte "Droplets" nachteilig bei der Ausbildung von Beschichtungen auf Substraten auswirken.

Die Schichtqualität wird so verschlechtert und es ist häufig eine zu hohe Rauhigkeit der Oberflächen gegeben, die eine mechanische Nachbearbeitung erforderlich machen kann. Letzteres ist aber bei Schichten aus harten Werkstoffen, wie z.B. amorphem, auch als diamantähnlicher Kohlenstoff bezeichnet, nicht oder nur mit sehr hohem Aufwand möglich.

Um diesem Problem entgegen zu wirken, hat es unterschiedliche Lösungsansätze gegeben. Dabei wurde in WO 00/13201 A1 der Einsatz einer Absorberelektrode vorgeschlagen, mit der ein positiver Einfluss, also eine Verringerung der Anzahl von auf eine sich ausbildende Schicht auftreffenden Partikeln erreicht werden soll.

Auf diesem Prinzip aufbauend wurde in DE 102 40 337 A1 vorgeschlagen zusätzlich ein magnetisches oder elektromagnetisches Feld auszubilden. Konkret sollen zwei Permanentmagnete oder elektrische Spulen eingesetzt werden zwischen denen ein von einem Target gebildetes Plasma hindurchgeführt werden soll.

Dabei kann der Abstand der Magnete oder Spulen aber nicht beliebig groß gewählt werden, um eine ausreichend große Feldstärke im Plasmavolumen zu gewährleisten. Dies wirkt sich insbesondere bei großen, insbesondere langgestreckten Targets nachteilig aus, die für die Beschichtung von großflächigen Substraten oder einer Vielzahl von zu beschichtenden Substraten aber gewünscht sind.

Bei der als "Laser-Arc-Verfahren" bezeichneten Technologie werden häufig lang gestreckte walzenförmige Targets eingesetzt, deren Länge ab 300 mm und aufwärts ist. Dabei wird eine gepulste Bogenentladung lokal gezielt mittels eines auf die rotierende Oberfläche eines Targets gerichteten Laserstrahls gezündet. Die nach einer vorgebbaren Zeit wieder zusammenbricht und nachfolgend eine erneute Zündung an einem anderen Ort der Targetoberfläche initiiert wird. So kann ein sehr gleichmäßiger Abtrag von Werkstoff vom Target und eine effektive Beschichtung von Substraten erreicht werden.

Bei solchen großen Targets kann aber eine aus DE 102 40 337 A1 bekannte Vorrichtung nicht ohne weiteres eingesetzt werden und es müssen mehrere Systeme nebeneinander in Reihe angeordnet sein, was für den Betrieb äußerst unvorteilhaft und häufig auch nicht praktikabel ist.

Aus der US 2002/0007796 A1 ist eine Vorrichtung zum Beschichten mit einer Filterung und einer Plasmabildung, die mit einer Bogenentladung erfolgt, bekannt.

Das US 5,840,163 betrifft eine Vakuum-Bogen-Plasmaquelle und eine Vorrichtung mit denen ein Plasma gebildet und auf ein Substrat gerichtet werden kann.

In US 4,929,321 sind ein Verfahren und eine Vorrichtung zum Beschichten von Werkstücken beschrieben.

Es ist daher Aufgabe der Erfindung eine einfach realisierbare Lösung vorzuschlagen, mit der Partikel aus einem für die Ausbildung von Beschichtungen gebildeten Plasma so separiert werden können, dass sie nicht auf die zu beschichtende Fläche eines Substrates auftreffen und dabei große Targets für die Plasmabildung eingesetzt werden können.

Erfindungsgemäß wird diese Aufgabe mit einer Anordnung, die die Merkmale des Anspruchs 1 aufweist, gelöst. Vorteilhafte Ausgestaltungen und Weiterbildungen der Erfindung können mit in den untergeordneten Ansprüchen bezeichneten Merkmalen erreicht werden.

Bei der erfindungsgemäßen Anordnung wird ein Plasma von einem Target, das als Kathode geschaltet sein kann, gebildet und dabei mit mindestens einer an ein in Bezug zum Plasma positives elektrisches Potential angeschlossenen Absorberelektrode positive Ladungsträger des Plasmas in Richtung auf eine zu beschichtende Fläche eines Substrates beschleunigt. Dabei soll die Absorberelektrode so angeordnet und ausgerichtet sein, dass ein direktes Auftreffen von Plasma auf die Absorberelektrode vermieden wird. So kann die Absorberelektrode beispielsweise plattenförmig oder einer ähnlichen Form gestaltet und in einem schräg geneigten Winkel ausgerichtet sein, der die Divergenz der Plasmaströmung berücksichtigt.

Zusätzlich ist mindestens ein Permanentmagnetelement oder Elektromagnet Bestandteil der Anordnung, das/der so angeordnet ist, dass das in Richtung auf ein Substrat beschleunigtes Plasma zwischen der Absorberelektrode und dem Permanentmagnetelement oder Elektromagnet hindurch geführt ist. Die Absorberelektrode ist also zwischen stabförmigen Permanentmagnetelement oder Elektromagnet und Plasma angeordnet.

Das Permanentmagnetelement oder der Elektromagnet sind dabei so dimensioniert, dass es/er zumindest bis an die seitlichen äußeren Ränder der Absorberelektrode geführt ist und dabei die für die Plasmabildung nutzbare Länge eines Targets berücksichtigt ist.

Dadurch kann ein sich ausbildendes Feld auch das in Richtung Substrat beschleunigte Plasma beeinflussen.

Durch geeignete Auswahl der Länge von Permanentmagnetelement oder Elektromagnet kann die magnetische Spannung optimiert werden, da sie proportional zur jeweiligen Länge ist. Die magnetische Feldstärke ist daher auch im Bereich des Plasmas konstant hoch.

Die Erfindung kann auch weitergebildet werden, indem ein zweites Permanentmagnetelement oder ein zweiter Elektromagnet eingesetzt wird. Dabei sollte eine Anordnung hinter bzw. im Schatten der Absorberelektrode gewählt werden. Die Absorberelektrode ist also zwischen stabförmigen Permanentmagnetelement oder Elektromagnet und Plasma angeordnet.

Dies berücksichtigt den Sachverhalt, dass die magnetische Feldstärke senkrecht zur Längsachse von Magneten abfällt. So kann eine Homogenisierung des magnetischen Feldes erreicht werden.

Dieses/dieser zweite Permanentmagnetelement oder Elektromagnet sollte die gleichen Abmaße, magnetischen Eigenschaften/Parameter und so auch die gleiche Ausrichtung der Polung aufweisen.

Permanentmagnetelemente können mit gestapelten einzelnen Permanentmagneten gebildet und so die jeweils erforderliche Länge erreicht werden.

Eine vorteilhafte Ausführung kann aber auch so ausgebildet sein, dass ein zweites Permanentmagnetelement oder ein Elektromagnet mit entgegengesetzter Polausrichtung wie das/der erste gemeinsam mit einer zweiten Absorberelektrode eingesetzt und so angeordnet wird, dass das Plasma zwischen diesen beiden jeweils gleich ausgebildeten Teileinheiten hindurchgeführt wird. Dies berücksichtigt den Sachverhalt, dass die magnetische Feldstärke senkrecht zur Längsachse von Magneten abfällt.

Mit einer solchen Ausführung kann das Plasma von zwei Seiten beeinflusst und durch die Feldwirkung verdichtet und eingeschnürt, also quasi fokussiert werden.

Im Bereich der Einschnürung des Plasmas kann dann vorteilhaft eine Blende mit einem freien Spalt angeordnet sein, durch den Plasma, bei dem bereits ein großer Teil an Partikeln separiert worden ist, auf eine zu beschichtende Fläche eines Substrates gerichtet und Partikel von der Blende zurück gehalten werden. So kann eine Reduzierung von zum Substrat gelangenden Partikeln um einen Faktor von 5, ohne eine Änderung der Richtung des Plasmas erreicht werden.

Es besteht aber auch noch die Möglichkeit zusätzlich ein(en) weiteres Permanentmagnetelement oder Elektromagneten einzusetzen. Dieses/dieser sollte zwischen den ersten und zweiten Permanentmagnetelementen oder Elektromagneten und dem Substrat angeordnet sein, so dass mit seiner Unterstützung eine Umlenkung des Plasmastromes in Richtung auf ein entsprechend versetzt angeordnetes Substrat erreichbar ist. Ein solches drittes Permanentmagnetelement oder dritter Elektromagnet sollte in Richtung des Plasmastromes nach der Einschnürung und bevorzugt geschützt hinter der spaltförmigen Blende neben dem Plasmastrom angeordnet sein.

Die einzelnen Permanentmagnetelemente oder Elektromagnete sollten eine Feldstärke von mindestens 10 mT aufweisen.

Die Beschichtung kann mit dem bereits in der Beschreibungseinleitung erwähnten Verfahren betrieben werden. Dabei kann Plasma mittels elektrischer Bogenentladung, die an der Oberfläche eines Targets gezündet wird, generiert werden. Dies kann in gepulster Form erfolgen. Dabei ist in der Nähe des Targets mindestens eine Anode angeordnet. Die Zündung kann wieder lokal gezielt mit einem auslenkbaren Laserstrahl initiiert werden. Dabei kann sich das Target um eine Achse drehen.

Permanentmagnetelemente oder Elektromagnete sollten bevorzugt parallel zur Rotationsachse ausgerichtet sein. Ihre Länge sollte der Länge des Targets in Richtung der Rotationsachse entsprechen oder größer sein. Auch sollte die Länge größer sein, als die Abmessungen der Absorberelektrode(n) in dieser Richtung, so dass sie diese überragen.

Nachfolgend soll die Erfindung an Hand von Beispielen näher erläutert werden.

Dabei zeigen:
Figur 1 ein Beispiel einer erfindungsgemäßen Anordnung mit einer Absorberelektrode und einem Permanentmagnetelement;
Figur 2 ein durch ein weiteres Permanentmagnetelement ergänztes Beispiel;
Figur 3 ein Beispiel mit zwei Permanentmagnetelementen und zwei Absorberelektroden;
Figur 4 ein Beispiel mit drei Permanentmagnetelementen und
Figur 5 ein weiteres Beispiel mit einer mit streifenförmigen Elementen gebildeten Absorberelektrode.

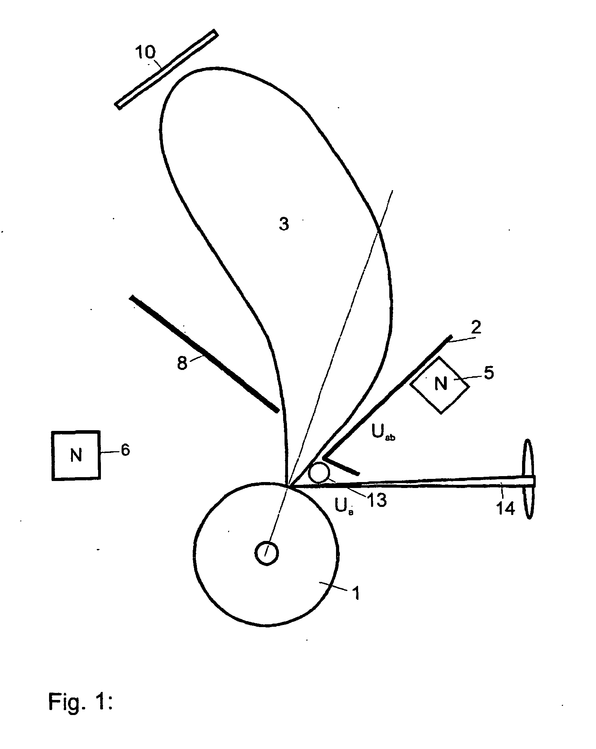

Mit Figur 1 ist ein Beispiel gezeigt bei dem ein sich drehendes walzenförmiges Target 1 eingesetzt ist. Dabei wird Plasma 3 mittels gepulster Bogenentladung vom Target 1 gebildet. Hierzu ist eine Anode 13 in der Nähe des Targets 1 angeordnet. Die Anode 13 erstreckt sich über die gesamte nutzbare Länge des Targets 1 in die Zeichnungsebene hinein. Diese Länge beträgt hier 400 mm. Die Zündung kann mit dem Laserstrahl 14 lokal gezielt gestartet werden.

Außerdem ist eine Absorberelektrode 2, die an ein gegenüber dem Plasma 3 elektrisch positives Potential angeschlossen ist, vorhanden. Diese kann ein entsprechend abgewinkeltes Metallblech sein. Wie der Darstellung entnommen werden kann, ist es in einem schräg geneigten Winkel ausgerichtet, um ein direktes Auftreffen von Bestandteilen des Plasmas zu vermieden.

Hinter der Absorberelektrode 2 ist ein zweites stabförmiges Permanentmagnetelement 5 und ein erstes Permanentmagnetelement 6 so angeordnet, dass beschleunigtes Plasma 3 zwischen Absorberelektrode 2 und erstem Permanentmagnetelement 6 in Richtung zum Substrat 10 hindurch geführt wird. Die Länge der beiden Permanentmagnetelemente 5 und 6 ist etwas größer, z.B. 200 mm länger, als die Länge der Absorberelektrode 2 in Richtung der Rotationsachse des Targets 1 ist, so dass sie über deren äußeren Ränder mit seinen Stirnseiten überstehen.

Auf der der Absorberelektrode 2 gegenüberliegenden Seite des Plasmas 3, also in der Richtung in der das Plasma 3 abgelenkt wird, ist eine Blende 8 angeordnet, mit der separierte Partikel abgefangen werden können.

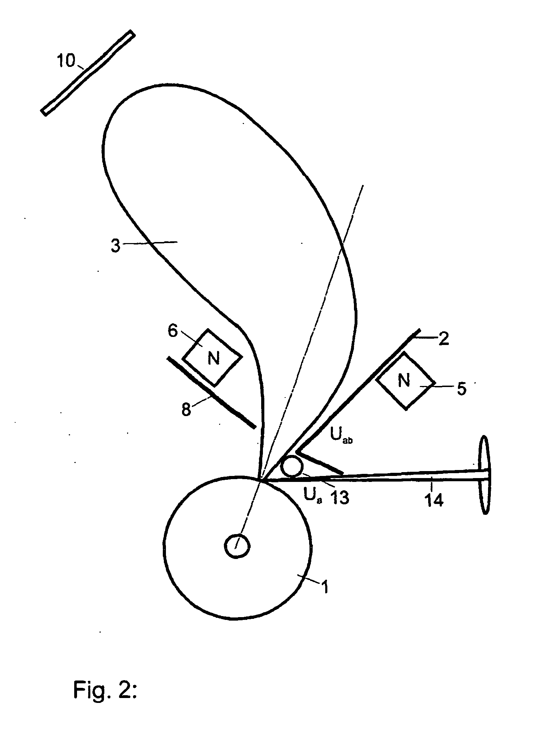

Bei dem in Figur 2 gezeigten Beispiel ist im Plasmaschatten der Blende 8 ein erstes Permanentmagnetelement 6 angeordnet, das die gleiche Polausrichtung, wie das zweite Permanentmagnetelement 5 hat, gleich dimensioniert, ausgerichtet ist und die gleichen magnetischen Parameter aufweist.

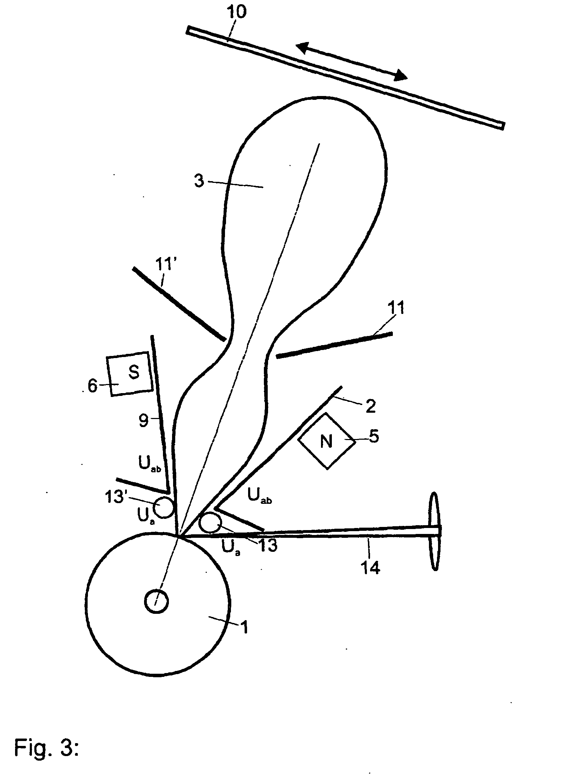

Bei dem Beispiel nach Figur 3 ist ein symmetrischer Aufbau um den Strom des Plasmas 3 in Richtung Substrat 10 gewählt worden. Es sind am Target 1 zwei Anoden 13, 13' zwei Absorberelektroden 2 und 9 sowie zwei Permanentmagnetelemente 5 und 6 an zwei sich gegenüberliegenden Seiten des Plasmas 3 angeordnet. Lediglich die Polausrichtung der Permanentmagnetelemente 5 und 6 ist entgegengesetzt gewählt.

Dadurch kann, wie der Darstellung zu entnehmen ist, eine Verdichtung in Form einer Einschnürung des Plasmastromes 3 erreicht werden. Die Einschnürung des Plasmastromes 3 ist hierbei in einem Bereich ausgebildet, in dem eine Blende 11 mit einem Spalt angeordnet ist. Der Spalt erstreckt sich dabei parallel zur Rotationsachse des Targets 1 über dessen Länge. Eine Richtungsänderung des Plasmastromes 3 in Richtung auf ein versetzt angeordnetes Substrat 10 erfolgt bei diesem Beispiel nicht zwingend.

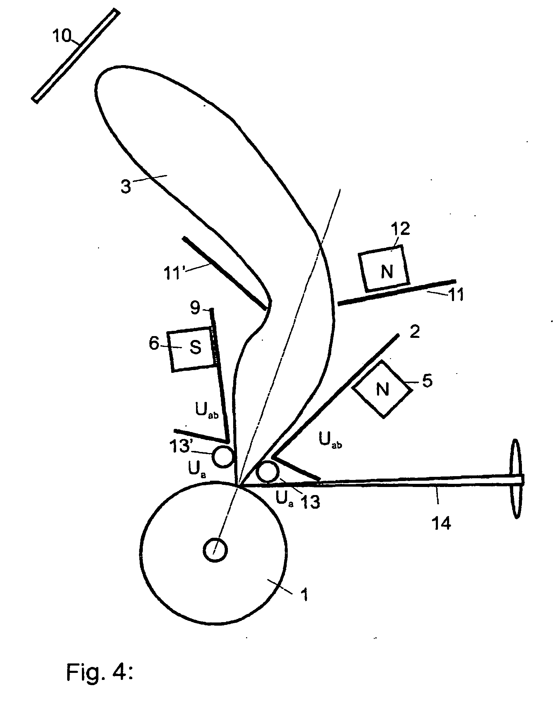

Dies kann aber mit einem dritten Permanentmagnetelement 12 erreicht werden, wie dies in Figur 4 gezeigt ist. Dieses ist an einer Seite des Plasmastromes 3 in der Nähe der Einschnürung und hier im Schatten eines Teils der Blende 11 angeordnet. Mit diesem Permanentmagnetelement 12 kann die Richtung des Plasmastromes 3 auf ein entsprechend versetzt angeordnetes Substrat 10 geändert und die Separationswirkung weiter erhöht werden.

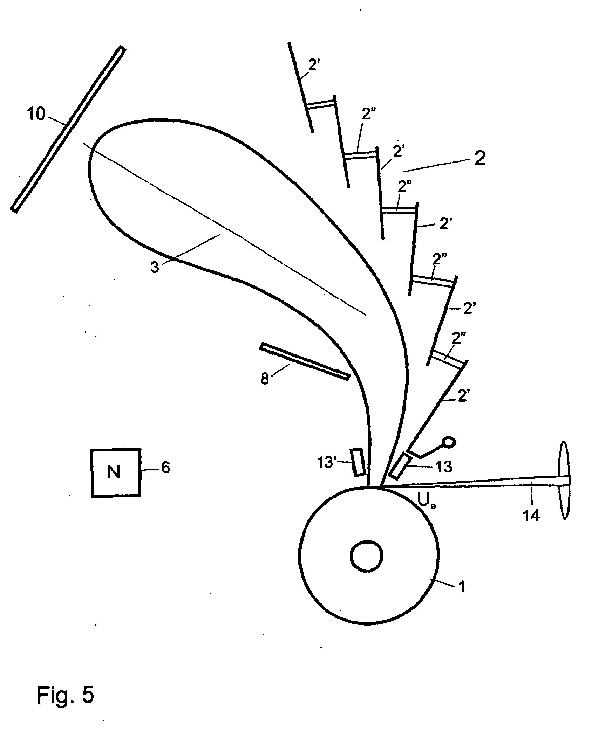

In Figur 5 ist ein weiteres Beispiel einer erfindungsgemäßen Anordnung schematisch gezeigt. Dabei sind oberhalb eines Targets 1 Anoden 13 und 13' angeordnet, um elektrische Bogenentladungen zu initiieren, deren Zündung lokal definiert mittels gepulster Laserstrahlung 14 erfolgen kann. Die Absorberelektrode 2 ist mit mehreren streifenförmigen Elementen 2' gebildet, die elektrisch leitend miteinander verbunden sind. Die streifenförmigen Elemente 2' sind mit Abstandshaltern 2'' verbunden. Durch die so gebildeten Zwischenräume zwischen den streifenförmigen Elementen 2' können schwerere Teilchen oder Partikel hindurch treten, ohne dass eine Reflexion in Richtung auf die Oberfläche eines Substrats 10 erfolgt.

Durch eine voneinander abweichende Winkelausrichtung von streifenförmigen Elementen 2' kann eine Bogenform der Absorberelektrode 2 in Richtung auf ein seitlich zum Target 1 angeordnetes Substrat 10 ausgebildet werden.

Das gebildete und in Richtung auf ein Substrat 10 beschleunigte Plasma 3 wird zwischen Absorberelektrode 2 und erstem Permanentmagnetelement 6 hindurch geführt und dabei von größeren Teilchen oder Partikeln frei in Richtung auf das seitlich vom Target 1 angeordnete Substrat 10 abgelenkt.

Auch bei diesem Beispiel ist eine Blende 8 vorhanden und auf der gleichen Seite in Bezug zum Plasma 3, wie auch das erste Permanentmagnetelement 6 angeordnet.

Die elektrische Kontaktierung der Absorberelektrode 2 mit einer elektrischen Spannungsversorgung ist in der Nähe deren Fußpunkts und demzufolge auch in der Nähe der Anode 13 angeordnet.

## Patentansprüche

1. Anordnung für die Separation von Partikeln aus einem Plasma bei einer Beschichtung von Substraten unter Vakuumbedingungen, bei der von einem Target ein Plasma gebildet und positive Ladungsträger des Plasmas mittels einer an ein gegenüber dem Plasma elektrisch positives Potential angeschlossenen Absorberelektrode zur Beschichtung des Substrates beschleunigt werden, dabei die Absorberelektrode so angeordnet und ausgerichtet ist, dass ein direktes Auftreffen von Bestandteilen des Plasmas vermieden ist,
**dadurch gekennzeichnet, dass**
die Absorberelektrode (2) und ein stabförmiges Permanentmagnetelement (6) oder ein stabförmiger Elektromagnet so angeordnet sind, dass in Reichtung auf das Substrat (10) beschleunigtes Plasma (3) zwischen Absorberelektrode (2) und stabförmigem Permanentmagnetelement (6) oder Elektromagnet hindurch geführt ist; wobei das stabförmige Permanentmagnetelement (6) oder der stabförmige Elektromagnet parallel zur Rotationsachse des sich drehenden Targets (1) ausgerichtet und in der Länge so dimensioniert ist, dass es/er zumindest bis an die äußeren Ränder der Absorberelektrode (2) geführt ist.

2. Anordnung nach Anspruch 1, **dadurch gekennzeichnet, dass** die Absorberelektrode (2) zwischen dem in Richtung auf das Substrat (10) beschleunigten Plasmas (3) und einem zweiten stabförmigen Permanentmagnetelement (5) oder einem Elektromagnet angeordnet ist.

3. Anordnung nach Anspruch 1 oder 2, **dadurch gekennzeichnet, dass** das erste und das zweite Permanentmagnetelement (5 und 6) oder die Elektromagnete die gleiche Polausrichtung aufweisen.

4. Anordnung nach einem der vorhergehenden Ansprüche, **dadurch gekennzeichnet, dass** das/der erste Permanentmagnetelement (6) oder Elektromagnet im Plasmaschatten einer Blende (8) angeordnet ist.

5. Anordnung nach einem der vorhergehenden Ansprüche, **dadurch gekennzeichnet, dass** auf der der ersten Absorberelektrode (2) gegenüberliegenden Seite des Plasmas (3) eine zweite Absorberelektrode (9) angeordnet ist und das/der erste Permanentmagnetelement (6) oder Elektromagnet hinter der zweiten Absorberelektrode (9) angeordnet ist und eine entgegengesetzte Polausrichtung zum ersten Permanentmagnetelement (5) oder Elektromagnet aufweist.

6. Anordnung nach einem der vorhergehenden Ansprüche, **dadurch gekennzeichnet, dass** zwischen den Permanentmagnetelementen (5 und 6) oder Elektromagneten und dem Substrat (10) eine spaltförmige Blende (11) angeordnet ist.

7. Anordnung nach einem der vorhergehenden Ansprüche, **dadurch gekennzeichnet, dass** zwischen erstem und/oder zweiten Permanentmagnetelement (5, 6) oder Elektromagnet(en) und Substrat (10) ein drittes/dritter Permanentmagnetelement (12) oder Elektromagnet zur seitlichen Ablenkung des Plasmas (3) in Richtung auf ein versetzt angeordnetes Substrat (10) angeordnet ist.

8. Anordnung nach Anspruch 7, **dadurch gekennzeichnet, dass** das/der dritte Permanentmagnetelement (12) oder dritte Elektromagnet im Bereich einer durch Einfluss der ersten und zweiten Permanentmagnetelemente (5, 6) oder Elektromagnete ausgebildeten Einschnürung des Plasmas (3) angeordnet ist.

9. Anordnung nach einem der vorhergehenden Ansprüche, **dadurch gekennzeichnet, dass** das/die Permanentmagnetelement(e) (5, 6, 12) mittels mehrerer gestapelter Einzelpermanentmagnete gebildet ist/sind.

10. Anordnung nach einem der vorhergehenden Ansprüche, **dadurch gekennzeichnet, dass** das Plasma (3) mittels Bogenentladung gebildet ist.

11. Anordnung nach einem der vorhergehenden Ansprüche, **dadurch gekennzeichnet, dass** zur Ausbildung einer Bogenentladung mindestens eine Anode (13, 13') zwischen Absorberlektrode(n) (2, 9) und Target (1) angeordnet ist.

12. Anordnung nach einem der vorhergehenden Ansprüche, **dadurch gekennzeichnet, dass** zur Zündung von Bogenentladungen ein Laserstrahl (14) auf die Oberfläche des Targets (1) gerichtet ist.

13. Anordnung nach einem der vorhergehenden Ansprüche, **dadurch gekennzeichnet, dass** das Target (1) als rotierende Walze ausgebildet ist.

14. Anordnung nach einem der vorhergehenden Ansprüche, **dadurch gekennzeichnet, dass** das/die Permanentmagnetelement(e) (5, 6, 12) oder der/die Elektromagnet(e) parallel zur Rotationsachse des Targets (1) ausgerichtet sind.

15. Anordnung nach einem der vorhergehenden Ansprüche, **dadurch gekennzeichnet, dass** Permanentmagnetelement(e) (5, 6, 12) oder Elektromagnet(e) eine Länge aufweisen, die mindestens der Länge des Targets (1) in Rotationsachsrichtung entspricht.

16. Anordnung nach einem der vorhergehenden Ansprüche, **dadurch gekennzeichnet, dass** ein Permanentmagnetelement (5, 6, 12) oder ein Elektromagnet eine magnetische Feldstärke von mindestens 10 mT aufweist.

17. Anordnung nach einem der vorhergehenden Ansprüche, **dadurch gekennzeichnet, dass** die Absorberelektrode (2) mit miteinander elektrisch leitend verbundenen und in Abständen zueinander angeordneten streifenförmigen Elementen (2') gebildet ist, die parallel zur Rotationsachse des Targets (1) und/oder zur Längsachse mindestens eines der Permanentmagnetelemente (5, 6, 12) oder Elektromagnete ausgerichtet sind.

18. Anordnung nach Anspruch 17, **dadurch gekennzeichnet, dass** die streifenförmigen Elemente (2') in voneinander abweichenden Winkeln ausgerichtet sind und dabei die Winkelneigung ausgehend vom Fußpunkt der Absorberelektrode (2) in Richtung auf ein seitlich dazu angeordnetes Substrat (10) zunimmt und so die Absorberlektrode (2) bogenförmig ausgebildet ist.

19. Anordnung nach einem der vorhergehenden Ansprüche, **dadurch gekennzeichnet, dass** die Absorberelektrode (2) in der Nähe ihres Fußpunktes an eine elektrische Spannungsversorgung angeschlossen ist.

## Claims

1. An arrangement for separating particles out of a plasma in the coating of substrates under vacuum conditions, in which a plasma is formed by a target and positive charge carriers of the plasma are accelerated by means of an absorber electrode, which is connected to a potential which is electrically positive with respect to the plasma, for coating the substrate, in so doing the absorber electrode is arranged and oriented such that direct impingement of constituents of the plasma is avoided, **characterised in that**
the absorber electrode (2) and a rod-shaped permanent magnet element (6) or a rod-shaped electromagnet are arranged such that plasma (3) which is accelerated in the direction of the substrate (10) is guided through between the absorber electrode (2) and the rod-shaped permanent magnet element (6) or electromagnet; the rod-shaped permanent magnet element (6) or the rod-shaped electromagnet being oriented parallel to the axis of rotation of the rotating target (1) and being of such a length that it is guided at least as far as the outer edges of the absorber electrode (2).

2. An arrangement according to Claim 1, **characterised in that** the absorber electrode (2) is arranged between the plasma (3) which is accelerated in the direction of the substrate (10) and a second rod-shaped permanent magnet element (5) or an electromagnet.

3. An arrangement according to Claim 1 or 2, **characterised in that** the first and the second permanent magnet element (5 and 6) or the electromagnets have the same pole orientation.

4. An arrangement according to one of the preceding claims, **characterised in that** the first permanent magnet element (6) or electromagnet is arranged in the plasma shadow of an aperture (8).

5. An arrangement according to one of the preceding claims, **characterised in that** a second absorber electrode (9) is arranged on the side of the plasma (3) located opposite the first absorber electrode (2), and the first permanent magnet element (6) or electromagnet is arranged behind the second absorber electrode (9) and has an opposite pole orientation to the first permanent magnet element (5) or electromagnet.

6. An arrangement according to one of the preceding claims, **characterised in that** a gap-shaped aperture (11) is arranged between the permanent magnet elements (5 and 6) or electromagnets and the substrate (10).

7. An arrangement according to one of the preceding claims, **characterised in that** a third permanent magnet element (12) or electromagnet for laterally deflecting the plasma (3) in the direction of a substrate (10) which is arranged offset is arranged between the first and/or second permanent magnet element (5, 6) or electromagnet(s) and the substrate (10).

8. An arrangement according to Claim 7, **characterised in that** the third permanent magnet element (12) or third electromagnet is arranged in the region of a constriction of the plasma (3) formed by the influence of the first and second permanent magnet elements (5, 6) or electromagnets.

9. An arrangement according to one of the preceding claims, **characterised in that** the permanent magnet element(s) (5, 6, 12) is/are formed by means of a plurality of stacked individual permanent magnets.

10. An arrangement according to one of the preceding claims, **characterised in that** the plasma (3) is formed by means of arc discharge.

11. An arrangement according to one of the preceding claims, **characterised in that** at least one anode (13, 13') is arranged between the absorber electrode(s) (2, 9) and the target (1) in order to form an arc discharge.

12. An arrangement according to one of the preceding claims, **characterised in that** a laser beam (14) is directed at the surface of the target (1) for igniting arc discharges.

13. An arrangement according to one of the preceding claims, **characterised in that** the target (1) is formed as a rotating roller.

14. An arrangement according to one of the preceding claims, **characterised in that** the permanent magnet element(s) (5, 6, 12) or the electromagnet(s) are oriented parallel to the axis of rotation of the target (1).

15. An arrangement according to one of the preceding claims, **characterised in that** permanent magnet element(s) (5, 6, 12) or electromagnet(s) have a length which corresponds to at least the length of the target (1) in the direction of the axis of rotation.

16. An arrangement according to one of the preceding claims, **characterised in that** a permanent magnet element (5, 6, 12) or an electromagnet has a magnetic field strength of at least 10 mT.

17. An arrangement according to one of the preceding claims, **characterised in that** the absorber electrode (2) is formed with strip-shaped elements (2') which are connected together in electrically conductive manner and are arranged spaced apart from each other, which are oriented parallel to the axis of rotation of the target (1) and/or to the longitudinal axis of at least one of the permanent magnet elements (5, 6, 12) or electromagnets.

18. An arrangement according to Claim 17, **characterised in that** the strip-shaped elements (2') are oriented at angles which differ from each other and in so doing the angular inclination increases starting from the foot of the absorber electrode (2) in the direction of a substrate (10) arranged laterally thereto and thus the absorber electrode (2) is made arcuate.

19. An arrangement according to one of the preceding claims, **characterised in that** the absorber electrode (2) is connected to an electric power supply in the vicinity of its foot.

## Revendications

1. Agencement pour la séparation de particules dans un plasma dans le cadre d'un recouvrement de substrats dans des conditions de vide, dans lequel un plasma est formé depuis une cible et des porteurs de charge positifs du plasma sont accélérés au moyen d'une électrode d'absorption rattachée à un potentiel électriquement positif par rapport au plasma en vue du recouvrement du substrat, où l'électrode d'absorption est agencée et orientée de telle sorte qu'un choc direct des parties constituantes du plasma est évité, **caractérisé en ce que** l'électrode d'absorption (2) et un élément d'aimant permanent en forme de barre (6) ou un électro-aimant en forme de barre sont agencés de telle sorte que du plasma (3) accéléré en direction du substrat (10) est amené de part et d'autre entre l'électrode d'absorption (2) et l'élément d'aimant permanent en forme de barre (6) ou l'électro-aimant, dans lequel l'élément d'aimant permanent en forme de barre (6) ou l'électro-aimant en forme de barre est orienté parallèlement à l'axe de rotation de la cible (1) en rotation et il est dimensionné de telle sorte dans sa longueur qu'il s'étend au moins jusqu'aux bords extérieurs de l'électrode d'absorption (2).

2. Agencement selon la revendication 1, **caractérisé en ce que** l'électrode d'absorption (2) est agencée entre le plasma (3) accéléré en direction du substrat (10) et un deuxième élément d'aimant permanent en forme de barre (5) ou un électro-aimant.

3. Agencement selon la revendication 1 ou 2, **caractérisé en ce que** le premier et le deuxième éléments d'aimants permanents (5 et 6) ou les électro-aimants présentent la même orientation de pôles.

4. Agencement selon l'une quelconque des revendications précédentes, **caractérisé en ce que** le premier élément d'aimant permanent (6) ou électro-aimant est agencé dans l'ombre du plasma d'un écran (8).

5. Agencement selon l'une quelconque des revendications précédentes, **caractérisé en ce qu'**une deuxième électrode d'absorption (9) est agencée sur le côté du plasma (3) situé à l'opposé de la première électrode d'absorption (2) et **en ce que** le premier élément d'aimant permanent (6) ou électro-aimant est agencé derrière la deuxième électrode d'absorption (9) et présente une orientation des pôles opposée par rapport au premier élément d'aimant permanent (5) ou électro-aimant.

6. Agencement selon l'une quelconque des revendications précédentes, **caractérisé en ce qu'**un écran en forme de fente (11) est agencé entre le substrat (10) et les éléments d'aimants permanents (5 et 6) ou les électro-aimants.

7. Agencement selon l'une quelconque des revendications précédentes, **caractérisé en ce qu'**un troisième élément d'aimant permanent (12) ou électro-aimant est agencé entre le substrat (10) et le premier et/ou deuxième élément d'aimant permanent (5, 6) ou électro-aimant(s) pour opérer une déviation latérale du plasma (3) en direction d'un substrat (10) agencé en décalage.

8. Agencement selon la revendication 7, **caractérisé en ce que** le troisième élément d'aimant permanent (12) ou troisième électro-aimant est agencé dans la zone d'un pincement du plasma (3) formé sous l'influence des premier et deuxième éléments d'aimants permanents (5, 6) ou électro-aimants.

9. Agencement selon l'une quelconque des revendications précédentes, **caractérisé en ce que** le ou les éléments d'aimants permanents (5, 6, 12) est/sont formé(s) au moyen de plusieurs aimants permanents individuels empilés.

10. Agencement selon l'une quelconque des revendications précédentes, **caractérisé en ce que** le plasma (3) est formé au moyen d'une décharge en arc.

11. Agencement selon l'une quelconque des revendications précédentes, **caractérisé en ce qu'**au moins une anode (13, 13') est agencée entre la ou les électrodes d'absorption (2, 9) et la cible (1) en vue de former une décharge en arc.

12. Agencement selon l'une quelconque des revendications précédentes, **caractérisé en ce qu'**un rayon laser (14) est dirigé vers la surface de la cible (1) en vue d'amorcer des décharges en arc.

13. Agencement selon l'une quelconque des revendications précédentes, **caractérisé en ce que** la cible (1) est conçue sous la forme d'un cylindre rotatif.

14. Agencement selon l'une quelconque des revendications précédentes, **caractérisé en ce que** le ou les éléments d'aimants permanents (5, 6, 12) ou le ou les électro-aimants sont orientés parallèlement à l'axe de rotation de la cible (1).

15. Agencement selon l'une quelconque des revendications précédentes, **caractérisé en ce que** le ou les éléments d'aimants permanents (5, 6, 12) ou le ou les électro-aimants présentent une longueur qui correspond au moins à la longueur de la cible (1) dans la direction de l'axe de rotation.

16. Agencement selon l'une quelconque des revendications précédentes, **caractérisé en ce qu'**un élément d'aimant permanent (5, 6, 12) ou un électro-aimant présente une intensité de champ magnétique d'au moins 10 mT.

17. Agencement selon l'une quelconque des revendications précédentes, **caractérisé en ce que** l'électrode d'absorption (2) est formée avec des éléments en forme de bandes (2') reliés les uns aux autres de manière électriquement conductrice et agencés à distance les uns des autres, lesquels éléments sont orientés parallèlement à l'axe de rotation de la cible (1) et/ou à l'axe longitudinal d'au moins un des éléments d'aimants permanents (5, 6, 12) ou électro-aimants.

18. Agencement selon la revendication 17, **caractérisé en ce que** les éléments en forme de bandes (2') sont orientés selon des angles s'éloignant les uns des autres et ce faisant, l'inclinaison des angles augmente à partir d'une racine de l'électrode d'absorption (2) dans la direction d'un substrat (10) agencé latéralement par rapport à celle-ci, de telle sorte que l'électrode d'absorption (2) prend la forme d'un arc.

19. Agencement selon l'une quelconque des revendications précédentes, **caractérisé en ce que** l'électrode d'absorption (2) est rattachée à proximité de sa racine à une alimentation en courant électrique.
